(19) Europäisches Patentamt / European Patent Office / Office européen des brevets

(11) **EP 3 591 976 B1**

(12) **EUROPEAN PATENT SPECIFICATION**

(45) Date of publication and mention of the grant of the patent:
**03.03.2021 Bulletin 2021/09**

(51) Int Cl.:
*H04N 19/70* (2014.01)      *H04N 19/91* (2014.01)
*H04N 19/82* (2014.01)      *H04N 19/463* (2014.01)

(21) Application number: **19191334.2**

(22) Date of filing: **27.06.2013**

(54) **DECOUPLING ENHANCEMENTS IN SAMPLE ADAPTIVE OFFSET (SAO) FOR HIGH EFFICIENCY VIDEO ENCODER (HEVC)**

ENTKOPPLUNGSVERBESSERUNGEN BEI SAMPLE-ADAPTIVE-OFFSET (SAO) FÜR HOCHEFFIZIENTE VIDEOKODIERER (HEVC)

PERFECTIONNEMENTS APPORTÉS AU DÉCOUPLAGE DANS UN DÉCALAGE ADAPTATIF D'ÉCHANTILLON (SAO) POUR CODEUR VIDÉO HAUT RENDEMENT (HEVC)

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **02.07.2012 US 201261667331 P**
          **02.07.2012 US 201261667321 P**
          **11.07.2012 US 201261670454 P**
          **13.03.2013 US 201313801553**

(43) Date of publication of application:
**08.01.2020 Bulletin 2020/02**

(62) Document number(s) of the earlier application(s) in accordance with Art. 76 EPC:
**13813646.0 / 2 853 033**

(73) Proprietor: **SONY Corporation**
**Tokyo 108-0075 (JP)**

(72) Inventors:
• **TABATABAI, Ali**
**Cupertino, CA 95014 (US)**
• **XU, Jun**
**Sunnyvale, CA 94086 (US)**

(74) Representative: **D Young & Co LLP**
**120 Holborn**
**London EC1N 2DY (GB)**

(56) References cited:
• **MAANI (SONY) E ET AL: "SAO Type Coding Simplification", 9. JCT-VC MEETING; 100. MPEG MEETING; 27-4-2012 - 7-5-2012; GENEVA; (JOINT COLLABORATIVE TEAM ON VIDEO CODING OF ISO/IEC JTC1/SC29/WG11 AND ITU-T SG.16 ); URL: HTTP://WFTP3.ITU.INT/AV-ARCH/JCTVC-SITE/,, no. JCTVC-I0246, 17 April 2012 (2012-04-17), XP030112009,**
• **SOLE J ET AL: "AhG6: Bypass bins grouping in SAO", 10. JCT-VC MEETING; 101. MPEG MEETING; 11-7-2012 - 20-7-2012; STOCKHOLM; (JOINT COLLABORATIVE TEAM ON VIDEO CODING OF ISO/IEC JTC1/SC29/WG11 AND ITU-T SG.16 ); URL: HTTP://WFTP3.ITU.INT/AV-ARCH/JCTVC-SITE/,, no. JCTVC-J0054, 26 June 2012 (2012-06-26) , XP030112416,**
• **MINEZAWA A ET AL: "Non-CE1: Improved edge offset coding for SAO", 9. JCT-VC MEETING; 100. MPEG MEETING; 27-4-2012 - 7-5-2012; GENEVA; (JOINT COLLABORATIVE TEAM ON VIDEO CODING OF ISO/IEC JTC1/SC29/WG11 AND ITU-T SG.16 ); URL: HTTP://WFTP3.ITU.INT/AV-ARCH/JCTVC-SITE/,, no. JCTVC-I0066, 16 April 2012 (2012-04-16), XP030111829,**

- BICI O ET AL: "Context reduction for merge index coding", 8. JCT-VC MEETING; 99. MPEG MEETING; 1-2-2012 - 10-2-2012; SAN JOSE; (JOINT COLLABORATIVE TEAM ON VIDEO CODING OF ISO/IEC JTC1/SC29/WG11 AND ITU-T SG.16 ); URL: HTTP://WFTP3.ITU.INT/AV-ARCH/JCTVC-SITE/,, no. JCTVC-H0251, 20 January 2012 (2012-01-20), XP030111278,

- SEREGIN V ET AL: "Bypass bins for reference index and delta QP coding", 9. JCT-VC MEETING; 100. MPEG MEETING; 27-4-2012 - 7-5-2012; GENEVA; (JOINT COLLABORATIVE TEAM ON VIDEO CODING OF ISO/IEC JTC1/SC29/WG11 AND ITU-T SG.16 ); URL: HTTP://WFTP3.ITU.INT/AV-ARCH/JCTVC-SITE/,, no. JCTVC-I0594, 3 May 2012 (2012-05-03), XP030112357,

**Description**

BACKGROUND OF THE INVENTION

1. Field of the Invention

This invention pertains generally to video encoding and decoding, and more particularly to enhanced signaling improvements to Sample Adaptive Offsets (SAO) within high-efficiency video coding (HEVC) systems.

2. Description of Related Art

A significant and ongoing demand continues for high efficiency video coding (HEVC) toward more optimal and scalable video compression. The Joint Collaborative Team on Video Coding (JCT-VC) of ITU-T and ISO/IEC MPEG continues enhancing a high efficiency video coding (HEVC) standard.

In HEVC, the frames are divided into coding tree blocks (CTBs) that can be further subdivided into coding units (CUs), such as using quadtree segmentation. A coding unit (CU) may have variable sizes depending on video content toward achieving a desired coding efficiency. CUs typically include a luminance component Y and two chroma components, U and V. The size of U and V components relate to the number of samples, and can be the same or different from that of the Y component, as depends upon the video sampling format. The CUs can be further subdivided into prediction unit (PU) partitions during intra-prediction and inter-prediction as well as transform units (TUs) defined for transform and quantization. Transform units (TU) generally refer to a block of residual data to which a transform is applied when generating transform coefficients.

HEVC introduces new elements over current video coding systems, such as H.264/AVC, and similar codecs. For example, although HEVC still involves motion compensated inter predictions, transforms, and entropy coding, it utilizes either arithmetic coding or variable length coding. In addition, following the deblocking filter is a sample adaptive offset (SAO) filter. The SAO filter unit operates once for each pixel in the CTB. For each CTB, a filter type and offset values are coded in the bitstream. There are two types of filters, specifically, edge and band filters. The band of a given sample is simply the upper 5 bits of its value. Then a band index is transmitted, along with the four offsets, that identifies four adjacent bands. So if the band index is 4, it means bands 4, 5, 6 and 7. If a pixel falls into one of these bands, the corresponding offset is added to it. In an edge filter an edge mode is transmitted (e.g., 0, 90, 45, 135 degrees). The offsets and filter modes are picked by the encoder toward making the CTB more closely match the source image.

The SAO filter considers the entire frame as a hierarchical quadtree. Quadrants in this quadtree are activated by the SAO transmitting syntax values which each represent an intensity band of pixel values referred to as band offset (BO) or the difference compared to neighboring pixel intensities referred to as edge offset (EO). For each type in SAO (BO and EO), transmitted offset values referred to as SAO offset are added to the corresponding pixels.

For example, HEVC working document 7 (WD 7) provides SAO on / off, 4 Edge Offset (EO) classes, and one Band Offset (BO). These SAO types are signaled to the decoder using a Unary code with two contexts for context-adaptive binary arithmetic coding (CABAC) coding, one on the first bin and one for the rest of the bins. In addition, for the BO type, band position is transmitted using FL codes. Context coded bins and by-pass coded bins are interleaved, which limit the CABAC engine throughput. A previously proposed arrangement is disclosed by Maani et al: "SAO Type Coding Simplification", JCTVC-I0246, April 2012.

The present invention provides forms of type decoupling which improve the efficiency of SAO signaling within a video coding system.

BRIEF SUMMARY OF THE INVENTION

The invention is defined by the appended claims. Further embodiments are provided as illustrative examples only. The present invention provides an improved mechanisms for enhanced signaling of SAO parameters exemplified in three primary inventive embodiments. The inventive apparatus and method changes SAO type coding in terms of syntax and binarization, provides new context modeling, and resolves interleaving of context coded bins and by-pass coded bins.

In a first embodiment (embodiment A), SAO on / off is enhanced by decoupling it with SAO on / off flags being jointly encoded for all color components. The lookup table for lcu_sao_enable idx is removed, with an equation utilized instead. Truncated unary binarization is utilized for the code index. Then only the first bin is context coded and the other bins are encoded using by-pass mode.

The second embodiment (embodiment B), is similar to embodiment A, but applicable to JCTVC-J0268. SAO type is encoded with single context. Only the first bin is context coded with one dedicated context, while the remaining bins are encoded in bypass mode.

The third embodiment (embodiment C), provides separate signaling for SAO on / off, SAO types BO and EO, and for BO and EO side information (classes or band position). SAO type is binarized by truncated unary and encoded with only one context for the first bin. EO classes are encoded using fixed length code and by-pass mode. Both context coded bins and by-pass coded bins are grouped to improve throughput of CABAC.

Further aspects of the invention will be brought out in the following portions of the specification, wherein the detailed description is for the purpose of fully disclosing preferred embodiments of the invention without placing limitations thereon.

BRIEF DESCRIPTION OF THE SEVERAL VIEWS OF THE DRAWING(S)

The invention will be more fully understood by reference to the following drawings which are for illustrative purposes only:

FIG. 1 is a schematic of a video encoder according to embodiments of the present invention.
FIG. 2 is a schematic of a video decoder according to embodiments of the present invention.
FIG. 3 is a flow diagram of a type first SAO (embodiment C) syntax according to an embodiment of the present invention.

DETAILED DESCRIPTION OF THE INVENTION

The inventive apparatus and method enhances SAO operation in HEVC encoders and decoders, while overcoming shortcomings of existing and proposed SAO signaling methods. In the developing High Efficiency Video Coding (HEVC) standard test model HM 7.0, each color component has one sample adaptive offset (SAO) type including on/off, EO types, and BO. Yet, it can be desirable to enhance SAO parameter signaling.

Introduction.

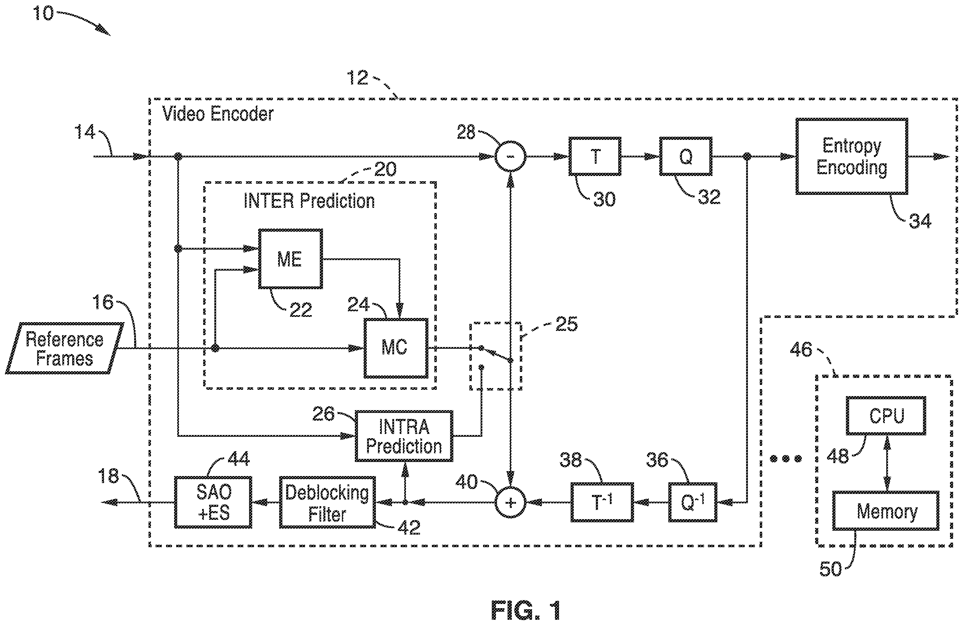

FIG. 1 illustrates an example embodiment of a coding apparatus comprising an encoder 10 according to the invention with enhanced sample adaptive offsets (SAO).
The encoder 10 is shown with encoding elements 12 executed by a computing means 46 exemplified with one or more processors 48, along with one or more memory devices 50. It will be appreciated that elements of the present invention can be implemented as programming stored on a media, which can be accessed for execution by a CPU for an encoder and / or decoder.
In the example, video frame input 14 is shown along with reference frames 16 and frame output 18. Inter-prediction 20 is depicted with motion estimation (ME) 22 and motion compensation (MC) 24. Intra-prediction 26 is shown with switching 25 depicted between inter-prediction and intra-prediction. A sum junction 28 is shown with output to a forward transform 30 which is performed based on the predictions to generate transform coefficients of residual data. Quantization of the transform coefficients is performed at quantization stage 32, which is followed by entropy encoding 34. Inverse quantization 36 and inverse transform 38 operations are shown coupled to a summing junction 40.
Output of summing junction 40, is a decoded video signal which is received by a deblocking filter 42, the Sample Adaptive Offset (SAO) filter with inventive enhanced signaling (+ES) 44 to produce an output 18. The enhanced signaling can be provided according to the present invention utilizing any of three embodiments which are described in detail in the following sections.

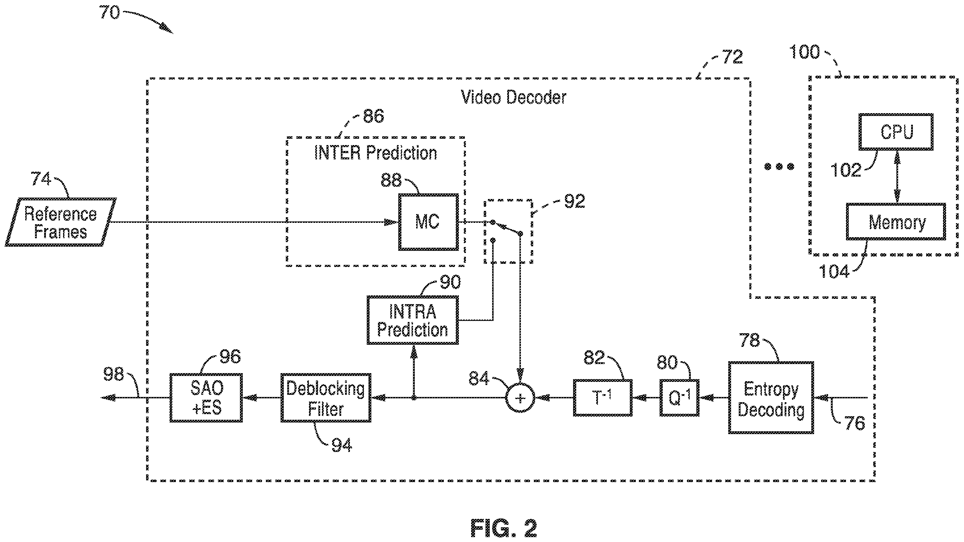

FIG. 2 illustrates an example embodiment 70 of a decoder, shown with process blocks 72 and an associated processing means 102. It will be noted that the decoder is substantially a subset of the elements contained in encoder 10 of FIG. 1, operating on reference frames 74 and outputting video signal 100. The decoder blocks receive an encoded video signal 76 which is processed through entropy decoder 78, inverse quantization 80, inverse transform 82, and summing 84 between the inverse transform 82 output and the selection 92 between inter-prediction 86 shown with motion compensation 88 and a separate intra-prediction block 90. Output from summing junction 84 is received by a deblocking filter 94, followed by SAO module with inventive enhanced signaling (+ES) 96 to produce a video output 98.
It should be appreciated that the decoder can be implemented with a processing means 100 which comprises at least one processing device 102 and at least one memory 104 for executing programming associated with the decoding. In addition, it will be noted that elements of the present invention can be implemented as programming stored on a media, wherein said media can be accessed for execution by processing device (CPU) 102.
It will be recognized that elements of the present invention 10 and 70 are implemented for execution by a processing means 46 and 100, such as in response to programming resident in memory 50 and 104 which is executable on computer processor (CPU) 48 and 102. In addition, it will be appreciated that elements of the present invention can be implemented as programming stored on a media, wherein said media can be accessed for execution by CPU 48 and / or 102.

It should also be appreciated that the above programming is executable from the memory which is a tangible (physical) computer readable media that is non-transitory in that it does not merely constitute a transitory propagating signal, but is actually capable of retaining programming, such as within any desired form and number of static or dynamic memory devices. These memory devices need not be implemented to maintain data under all conditions (e.g., power fail) to be considered herein as non-transitory media.

A. Embodiment A: Simplification of JCTVC-10193.

The enhancement to the decoupling of SAO on / off and types can be performed in two different variations. In the first two variations SAO on / off are decoupled from SAO type coding, with SAO on / off flags being encoded jointly for all color components.

In this first variation, a simplified JCTVC-10193 embodiment is provided which combines SAO flags with the following changes. (1) The look-up table (e.g., Table 1) is replaced and a code index is generated with an equation as follows:

$$\text{code index} = (\text{lcu\_sao\_enable\_flagCr} \ll 2) +$$

$$(\text{lcu\_sao\_enable\_flagCb} \ll 1) + \text{lcu\_sao\_enable\_flagY}$$

In the above equation, truncated unary binarization is utilized for the code index. Only the first bin is context coded and other bins are encoded in the by-pass mode.

The type coding, seen in Table 2, and offset coding then remain the same as JCTVC-10193 extended to HM7.0.

Table 3 illustrates an example of slice data syntax.

Table 4 illustrates SAO parameter syntax with descriptor.

Table 5 illustrates type information for BO and EO. The value sao_band_position [ cldx ][ rx ][ry ] indicates the displacement of the band offset of the pixel range when sao_type_idx [ cldx ][ rx ][ ry ] is equal to 4. The value sao_offset_sign[ cldx ][ rx ][ry ][ i ] specifies the sign of sao_offset[cldx ][ rx ][ry ][ i ] when sao_type_index is equal to 4. The variable offset sign is derived as follows. If sao_type_idx [ cldx ][ rx ][ry ] is less than 4 and i is larger than 1, offset sign is set to -1. Otherwise (sao_type_idx [ cldx ][ rx ][ry ] is equal to 4 or i is less than 2), offset sign is set to 1.

Table 6 illustrates how lcu_sao_enable_idx specifies the LCU SAO enable flag values of three color components.

B. Embodiment B: JCTVC-J0268 + Simplification of JCTVC-10193.

In this embodiment, the simplified solution above is combined with the solution from JCTVC-J0268 on SAO signaling to provide an enhanced signaling structure for SAO. This results in a small change in the SAO type due to the decoupling of SAO on / off in simplifying JCTVC-10193 described above. The SAO signaling of the combined solution is listed in order as follows: (1) First, the SAO on/off index for three on/off flags from all color components is signaled. The index is binarized using truncated unary code. Only the first bin is context coded with one dedicated context. The rest of the bins are encoded in by-pass mode. For each color component, if SAO is enabled, then the process moves to the next step (step 2); otherwise, finish SAO signaling. (2) SAO type as shown in Table 7 is encoded with one context. (3) Offsets including absolute values and signs are encoded as HM7.0 does. (4) If the SAO type is EO, then EO classes are signaled using sao_eo_class as shown in Table 8, which is encoded by FLC with by-pass. (5) If SAO type is BO, then band positions are signaled as HM7.0 does.

Table 9 illustrates a specification of slice data syntax.

Table 10 provides an example of SAO parameter syntax for this embodiment.

Table 11 illustrates specifying SAO type.

Table 12 illustrates how lcu_sao_enable_idx indicates the LcuSaoEnableFlag values of three color components.

Table 13 exemplifies the parameter sao_eo_class[ cldx ][ rx ][ ry ] indicating edge offset type of the current coding tree block at position rx and ry for the color component cldx. When sao_eo_class [ cldx ][ rx ][ ry ] is not present, it is inferred as follows.

If sao_merge_left_flag is equal to 1, then

sao_eo_class[ cldx ][ rx ][ ry ]

is set equal to

sao_eo_class [ cldx ][ rx - 1 ][ ry ].

Otherwise, if sao_merge_up_flag is equal to 1, then

sao_eo_class[ cldx][ rx ][ ry ]

is set equal to

sao_eo_class [cldx][ rx ][ ry - 1 ].

Otherwise, sao_merge_up_flag is not equal to 1, whereby sao_eo_class [ cldx ][ rx ][ ry ] is set equal to 0.

The parameter sao_band_position[ cldx ][ rx ][ ry ] indicates the displacement of the band offset of the pixel range when sao_type_idx[ cldx ][ rx ][ ry ] is equal to 0.

The parameter sao_offset_sign[ cldx ][ rx ][ ry ][ i ] specifies the sign of sao_offset[ cldx ][ rx ][ ry ][ i ] when sao_type_index is equal to 0.

The variable offsetSign is derived as follows.

If sao_type_idx[ cldx ][ rx ][ ry ] is equal to 1 and i is greater than 1, offsetSign is set equal to -1.

Otherwise, if sao_type_idx[ cldx ][ rx ][ ry ] is equal to 1 and i is less than 2, offsetSign is set equal to 1.

C. Embodiment C: Type First SAO coding, .

In this embodiment the coding of SAO type is reconfigured to have separate signaling for SAO On / Off, SAO type BO and EO and EO / BO side information (classes or band positions). The embodiment also groups both context coded bins and by-pass coded bins to improve throughput for context-based adaptive binary arithmetic coding (CABAC).

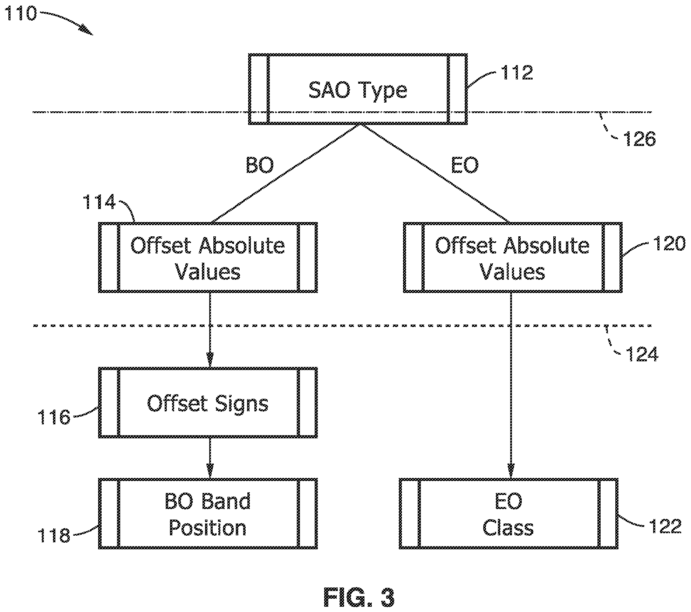

FIG. 3 illustrates an example embodiment 110 of another SAO enhanced signaling mechanism according to the present invention spread across context and bypass coding. Two variations are shown according to which portions are context coded versus by-pass coded. SAO type is selected 112, with absolute values coded for band offset (BO) 114, or alternatively, edge offset (EO) 120. Coding offset signs are passed 116 for BO followed by BO band position 118. For edge offset coding, EO class is sent 122.

Two dashed lines 124, 126 are seen in the flowchart depicting two different separations of context coding (operations seen above the line), versus by-pass coding (operations seen below the line). For example, in one variation the flowchart steps above dashed line 124 represent context coded steps, while steps below line 124 represent steps coded with bypass coding. For example, SAO type 112, and offset absolute values for BO and EO are depicted above line 124, and thus are context coded. The coding of offset signs 116, BO band position 118, and EO class 122, are by-pass coded.

Considering dashed line position 126 seen passing through SAO type block 112, here a portion (e.g., first bin) of the SAO is context coded while the remaining bins are block coded. In either case, it can be seen from the flowchart that embodiment C provides a balanced signaling structure for EO and BO.

Current SAO types (in HEVC WD 7) consist of SAO on / off, 4 Edge Offset (EO) classes, and one Band Offset (BO). These options (SAO types) are signaled to the decoder using a Unary code with two contexts (e.g., CABAC coding), one on the first bin and one for the rest of the bins. In addition, for the BO type, band position is transmitted using FL codes.

The present invention considers that in providing a more regularized structure, the process can be improved in at least four different ways, as outlined. (1) While there are only two actual types in SAO (namely EO and BO), the SAO types in current design consists of 4 EO classes, yet only 1 BO. Therefore, the extra context in CABAC mode cannot track the statistics of EO versus BO. (2) The four EO classes correspond to 4 directions but have very different code lengths. Logically, due to the symmetry in a large-enough set of images, there should not be an advantage to a direction compared to the rest. This has been confirmed even on the HEVC test set which is a much smaller test set. The numbers of occurrences of the four directions are almost uniformly distributed hence FL codes are used. (3) Side information is transmitted only in BO. Side information for the EO classes (directions), however, are coded with SAO type and on/off switch. (4) Context coded bins and by-pass coded bins are interleaved in the current WM 7, because band positions of BO are encoded in by-pass mode before offsets coded with contexts.

In this embodiment of the invention, SAO type is first signaled and side information (i.e., EO classes and BO band position) is signaled separately. This configuration provides a balanced structure, reduced branches and improved throughput. These changes are itemized as follows. (a) The SAO type (sao_type_idx) is reduced to indicate only SAO on / off, BO and EO as shown in Table 14. (b) Parameter sao_type_idx is binarized using truncated unary. In one alternative context modeling is coded with only one context for the first bin and bypass coding for the second bin, or coded with two contexts: one for the first bin and the other for the second bin. (c) EO classes are signaled using sao_eo_class as is the same as that shown in Table 10, which is encoded by FLC with by-pass. (d) Reordering of syntax to avoid interleaving of context coded bins and by-pass coded bins.

These changes operate to reduce the number of context coded bins for SAO syntax (including SAO type and BO/EO information).

The following describes aspects of the SAO parameter semantics which were shown in Table 14. Parameter sao_eo_class[ cldx ][ rx ][ ry ] indicates the edge offset type as specified in Table 15 of current coding tree block at position rx and ry for the color component cldx.

Table 16 provides examples of variable initialization for sao_Type_Idx ctxIdx.

Table 17 illustrates syntax and binarization types for selected variables.

Interleaving Issue.

In the current HEVC WD7 and JCTVC-I0246, context coded bins and by-pass coded bins are interleaved. This interleaving limits the throughput of the CABAC engine. To resolve the interleaving issue, one element of the present invention reorders the syntax to group each category and have the context coded bin group before the by-pass coded bin group.

Embodiments of the present invention may be described with reference to flowchart illustrations of methods and systems according to embodiments of the invention, as well as algorithms, formulae, or other computational depictions, which may also be implemented as computer program products. In this regard, each block or step of a flowchart, and combinations of blocks (steps, or a combination thereof) in a flowchart, algorithm, formula, or computational depiction can be implemented by various means, such as hardware, firmware, software including one or more computer program instructions embodied in computer-readable program code logic. As will be appreciated, any such computer program instructions may be loaded onto a computer, including without limitation a general purpose computer or special purpose computer, or other programmable processing apparatus to produce a machine, such that the computer program instructions which execute on the computer or other programmable processing apparatus create means for implementing the functions specified in the block(s) of the flowchart(s).

Accordingly, blocks of the flowcharts, algorithms, formulae, or computational depictions support combinations of means for performing the specified functions, combinations of steps for performing the specified functions, and computer program instructions, such as embodied in computer-readable program code logic means, for performing the specified functions. It will also be understood that each block of the flowchart illustrations, algorithms, formulae, or computational depictions and combinations thereof described herein, can be implemented by special purpose hardware-based computer systems which perform the specified functions or steps, or combinations of special purpose hardware and computer-readable program code logic means.

Furthermore, these computer program instructions, such as embodied in computer-readable program code logic, may also be stored in a computer-readable memory that can direct a computer or other programmable processing apparatus to function in a particular manner, such that the instructions stored in the computer-readable memory produce an article of manufacture including instruction means which implement the function specified in the block(s) of the flowchart(s). The computer program instructions may also be loaded onto a computer or other programmable processing apparatus to cause a series of operational steps to be performed on the computer or other programmable processing apparatus to produce a computer-implemented process such that the instructions which execute on the computer or other programmable processing apparatus provide steps for implementing the functions specified in the block(s) of the flowchart(s), algorithm(s), formula(e), or computational depiction(s).

Table 1

| Prior Art) Mapping of LCU SAO enable flags to a lcu_sao_enable _idx_index | | | | |
|---|---|---|---|---|
| **LCU SAO enable flag** | | | **Combination index** | **Code index (lcu_sao_enable_idx)** |
| **Y** | **Cb** | **Cr** | | |
| 0 | 0 | 0 | 0 | 0 |
| 0 | 0 | 1 | 1 | 5 |
| 0 | 1 | 0 | 2 | 6 |
| 0 | 1 | 1 | 3 | 7 |
| 1 | 0 | 0 | 4 | 1 |
| 1 | 0 | 1 | 5 | 2 |
| 1 | 1 | 0 | 6 | 3 |
| 1 | 1 | 1 | 7 | 4 |

Table 2

| (Prior Art) SAO type table in JCTVC-10193 | |
|---|---|
| **sao_type_idx** | **SAO type** |
| 0 | 1D 0-degree edge |

(continued)

| (Prior Art) SAO type table in JCTVC-10193 | |
|---|---|
| **sao_type_idx** | **SAO type** |
| 1 | 1D 90-degree edge |
| 2 | 1D 135-degree edge |
| 3 | 1D 45-degree edge |
| 4 | Band |

Table 3

| Embodiment A - Slice Data Syntax with Descriptor | |
|---|---|
| **slice_data( ) {** | **Desc.** |
| CtbAddrRS = SliceCtbAddrRS | |
| CtbAddrTS = CtbAddrRStoTS[ CtbAddrRS ] | |
| moreDataFlag = 1 | |
| if( adaptive loop filter flag && alf cu control flag ) | |
| AlfCuFlagIdx = -1 | |
| do { | |
| xCtb = InverseRasterScan( CtbAddrRS, CtbSize, CtbSize, pic width in luma samples, 0 ) | |
| yCtb = InverseRasterScan( CtbAddrRS, CtbSize, CtbSize, pic width in luma samples, 1 ) | |
| NumPCMBlock = 0 | |
| CtbAddrInSlice = CtbAddrRS - ( slice address >> SliceGranularity ) | |
| if( slice_sample_adaptive_offset_flag[ 0 ] ) | |
| **lcu_sao_enable_idx** | ae(v) |
| for( cIdx = 0; cIdx < 3; cIdx++ ) { | |
| if( slice_sample_adaptive_offset_flag[ cIdx ] &&LcuSaoEnableFlag[ 0 ][ xCtb ] [ yCtb ]) | |
| sao_param( xCtb, yCtb, cIdx ) | |
| } | |
| moreDataFlag = coding_tree( xCtb, yCtb, Log2CtbSize, 0 ) | |
| CtbAddrTS++ | |
| CtbAddrRS = CtbAddrTStoRS[CtbAddrTS ] | |
| if( moreDataFlag && ((tiles or entropy coding sync _idc = = 1 && TileId[ CtbAddrTS] != TileId[ CtbAddrTS - 1 ] ) \|\| (tiles_or_entropy_coding_sync_idc = = 2 && CtbAddrTS % PicWidthInCtbs = = 0 ) ) ) | |
| rbsp_ alignment( ) | |
| } while( moreDataFlag ) | |
| } | |

Table 4

| Embodiment A: SAO Parameter Syntax with Descriptor | |
|---|---|
| sao_param( rx, ry, cldx ) { | **Desc.** |
|     if( rx > 0 ) { | |
|         leftCtbInSlice = CtbAddrInSlice > 0 | |
|         leftCtbInTile = TileId[ CtbAddrTS] = = TileId[ CtbAddrRStoTS[ CtbAddrRS - 1 ] ] | |
|         if(leftCtbInSlice && leftCtbInTile&& LcuSaoEnableFlag[cldx ][ rx - 1][ ry ] ) | |
|             **sao merge_ left_flag** | ae(v) |
|     } | |
|     if( ry > 0 && ! sao _merge_left_flag ) { | |
|         upCtbInSlice = (CtbAddrTS - CtbAddrRStoTS[CtbAddrRS - PicWidthInCtbs]) <= CtbAddrInSlice | |
|         upCtbInTile = TileId[CtbAddrTS] = = TileId[CtbAddrRStoTS[ CtbAddrRS - PicWidthInCtbs ] ] | |
|         if(upCtbInSlice && upCtbInTile&& LcuSaoEnableFlag[cldx ][ rx - 1][ ry ] ) | |
|             **sao_merge_up_flag** | ae(v) |
|     } | |
|     if( !sao_merge_up_flag && !sao_merge_left_flag&& LcuSaoEnableFlag[cldx][rx][ ry ] ) { | |
|         **sao_type_idx** [ cldx ][ rx ][ ry ] | ae(v) |
|         if( sao_type_idx[ cldx ][ rx ][ ry ]= =5 ) | |
|             **sao_band_position** [ cldx ][ rx ][ ry ] | ae(v) |
|         if( sao_type_idx[ cldx ][ rx ][ ry ]!= 0 ) | |
|           for( i = 0; i < 4; i++ ) | |
|               **sao_offset_abs**[ cldx ][ rx ][ ry ][ i ] | ae(v) |
|         if( sao_type_idx[ cldx ][ rx ][ ry ]= = 5 ) { | |
|           for( i = 0; i < 4; i++ ) { | |
|              if( sao_offset_abs[ cldx ][ rx ][ ry ]!= 0) | |
|                 **sao_offset_sign**[ cldx ][ rx ][ ry ][ i ] | ae(v) |
|           } | |
|         } | |
|     } | |
| } | |

Table 5

| Embodiment A: Specifying SAO Type | |
|---|---|
| **sao_type_idx[ cldx][ rx][ ry ]** | **SAO type (informative)** |
| 0 | ID 0-degree edge offset |
| 1 | ID 90-degree edge offset |
| 2 | ID 135-degree edge offset |
| 3 | ID 45-degree edge offset |
| 4 | Band offset |

Table 6

| Embodiment A: Specifying SAO Slice Data Semantics | | | |
|---|---|---|---|
| lcu_ sao_enable_ idx | LcuSaoEnableFlag[ cldx][rx][ry] | | |
| | cldx = 0 | cldx = 1 | cldx = 2 |
| 0 | 0 | 0 | 0 |
| 1 | 1 | 0 | 0 |
| 2 | 0 | 1 | 0 |
| 3 | 1 | 1 | 0 |
| 4 | 0 | 0 | 1 |
| 5 | 1 | 0 | 1 |
| 6 | 0 | 1 | 1 |
| 7 | 1 | 1 | 1 |

Table 7

| Embodiment B: SAO Types in JCTVC-J0268 + simplfied JCTVC-10193 | |
|---|---|
| sao_type_idx[cldx][rx][ry] | SAO type (informative) |
| 0 | Band Offset (BO) |
| 1 | Edge Offset (EO) |

Table 8

| Embodiment B: SAO Edge Offset Class | |
|---|---|
| sao_type_idx [cldx][rx][ry] | SAO EO Class |
| 0 | 1D 0-degree edge |
| 1 | 1D 90-degree edge |
| 2 | 1D 135-degree edge |
| 3 | 1D 45-degree edge |

Table 9

| Embodiment B: Specification of Slice Data Syntax | |
|---|---|
| slice_data( ) { | Descriptor |
| CtbAddrRS = SliceCtbAddrRS | |
| CtbAddrTS = CtbAddrRStoTS[ CtbAddrRS ] | |
| moreDataFlag = 1 | |
| if( adaptive_loop_filter_flag&& alf_cu_control_flag ) | |
| AlfCuFlagIdx = -1 | |
| do { | |
| xCtb = InverseRasterScan( CtbAddrRS, CtbSize, CtbSize, pic_width_in_luma_ samples, 0 ) | |

(continued)

| Embodiment B: Specification of Slice Data Syntax | |
|---|---|
| slice_data( ) { | Descriptor |
|         yCtb = InverseRasterScan( CtbAddrRS, CtbSize, CtbSize, pic_width_in_luma_ samples, 1 ) | |
|     NumPCMBlock = 0 | |
|     CtbAddrInSlice = CtbAddrRS - ( slice_address >> SliceGranularity ) | |
|     if( slice_sample_adaptive_offset_flag[ 0 ]) | |
|         **lcu_sao_enable_idx** | ae(v) |
|     for( cIdx = 0; cIdx < 3; cIdx++ ) { | |
|         if( slice-sample-adaptive-offset-flag[ cIdx ]&&LcuSaoEnableFlag[ 0 ][ xCtb ] [ yCtb ]) | |
|             sao_param( xCtb, yCtb, cIdx ) | |
|     } | |
|     moreDataFlag = coding_tree( xCtb, yCtb, Log2CtbSize, 0 ) | |
|     CtbAddrTS++ | |
|     CtbAddrRS = CtbAddrTStoRS[CtbAddrTS ] | |
|     if( moreDataFlag && ((tiles_or_entropy-coding_sync_idc = = 1 &&         TileId[CtbAddrTS ] != TileId[CtbAddrTS - 1]) \|\|         ( tiles_or_entropy_coding_sync_idc = = 2 && CtbAddrTS % PicWidthInCtbs = = 0 ) ) ) | |
|         rbsp_alignment( ) | |
|   } while( moreDataFlag ) | |
| } | |

Table 10

| Embodiment B: SAO Parameter Syntax | |
|---|---|
| sao_param( rx, ry, cIdx ){ | Descriptor |
|   if( rx > 0 ) { | |
|     leftCtbInSlice = CtbAddrInSlice > 0 | |
|     leftCtbInTile = TileId[ CtbAddrTS ] = = TileId[CtbAddrRStoTS[ CtbAddrRS - 1 ] ] | |
|     if(leftCtbInSlice && leftCtbInTile&& LcuSaoEnableFlag[ cIdx ][ rx -1][ ry ] ) | |
|         **sao_merge_left_flag** | ae(v) |
|   } | |
|   if( ry > 0 && !sao_merge_left_flag ) { | |
|     upCtbInSlice = (CtbAddrTS - CtbAddrRStoTS[CtbAddrRS - PicWidthInCtbs]) <= CtbAddrInSlice | |
|     upCtbInTile = TileId[ CtbAddrTS] = = TileId[ CtbAddrRStoTS[ CtbAddrRS - PicWidthInCtbs ] ] | |
|     if( upCtbInSlice && upCtbInTile&& LcuSaoEnableFlag[cIdx ][ rx - 1][ ry ] ) | |
|         **sao_merge_up_flag** | ae(v) |
|   } | |
|   if (!sao_merge_up_flag && !sao_merge_left_flag&& LcuSaoEnableFlag[ cIdx ][ rx ][ ry ] ) { | |

(continued)

| Embodiment B: SAO Parameter Syntax | |
|---|---|
| sao_param( rx, ry, cldx ){ | Descriptor |
|     **sao_type_idx**[cldx][ rx ][ ry ] | ae(v) |
|     if( sao_type_idx[ cldx ][ rx ][ ry ] != 0 ) | |
|       for( i = 0; i < 4; i++ ) | |
|         **sao_offset_abs**[ cldx ][ rx][ ry ][ i ] | ae(v) |
|     if( sao_type_idx[ cldx ][ rx ][ ry ] = = 5 ) { | |
|       for( i = 0; i < 4; i++) { | |
|         if( sao_offset_abs[ cldx ][ rx ][ ry ]!=0 ) | |
|           **sao_offset_sign**[ cldx ][ rx ][ ry ][ i ] | ae(v) |
|         } | |
|       } | |
|       **sao_band_position**[ cldx ][ rx ][ ry ] | ae(v) |
|     } | |
|     else | |
|       **sao_eo_class**[ cldx ][ rx ][ ry ] | ae(v) |
|   } | |
| } | |

Table 11

| Embodiment B: Specification of SAO Type | |
|---|---|
| **sao_type_idx[cldx][ rx][ry]** | **SAO type (informative)** |
| 0 | Band offset |
| 1 | Edge offset |

Table 12

| Embodiment B: Specification of LcuSaoEnableFlag for Three Color Components | | | |
|---|---|---|---|
| **lcu_sao_enable_idx** | LcuSaoEnableFlag[ cldx][ rx][ry] | | |
| | cldx = 0 | cldx = 1 | cldx = 2 |
| 0 | 0 | 0 | 0 |
| 1 | 1 | 0 | 0 |
| 2 | 0 | 1 | 0 |
| 3 | 1 | 1 | 0 |
| 4 | 0 | 0 | 1 |
| 5 | 1 | 0 | 1 |
| 6 | 0 | 1 | 1 |
| 7 | 1 | 1 | 1 |

Table 13

| Embodiment B: Specification of hPos and vPos for SAO | | | | |
|---|---|---|---|---|
| sao_eo_class[cldx][ rx ][ry] | 0 | 1 | 2 | 3 |
| hPos[0] | -1 | 0 | -1 | 1 |
| hPos[1] | 1 | 0 | 1 | -1 |
| vPos[0] | 0 | -1 | -1 | -1 |
| vPos[1] | 0 | 1 | 1 | 1 |

Table 14

| Embodiment C: Specification of SAO Type | |
|---|---|
| sao_type_idx[cldx][ rx][ry] | SAO type (informative) |
| 0 | Not applied |
| 1 | Band offset |
| 2 | Edge offset |

Table 15

| Embodiment C: Specification of SAO Edge Offset Class | |
|---|---|
| sao_eo_class[cldx][ rx][ry] | SAO edge offset class (informative) |
| 0 | 1D 0-degree edge offset |
| 1 | 1D 90-degree edge offset |
| 2 | 1D 135-degree edge offset |
| 3 | 1D 45-degree edge offset |

Table 16

| Embodiment C: Examples of Variable initValue for sao_type_idxldx | | | | | | |
|---|---|---|---|---|---|---|
| Init variable | sao_type_idx ctxldx | | | | | |
| | 0 | 1 | 2 | 3 | 4 | 5 |
| initValue | 200 | 157 | 185 | 157 | 160 | 157 |

Table 17

| Embodiment C: Syntax and Binarization Types for Select Variables | | | | | |
|---|---|---|---|---|---|
| Syntax element | initType | Type of binarization | maxBinIdxC tx | ctxidxTable | ctxidxOffset |
| sao_type_idx | 0 | TU, cMax = 2 | 1 | Table 16 | 0 |
| | 1 | | 1 | Table 16 | 2 |
| | 2 | | 1 | Table 16 | 4 |

(continued)

| Embodiment C: Syntax and Binarization Types for Select Variables | | | | | |
|---|---|---|---|---|---|
| **Syntax element** | **initType** | **Type of binarization** | **maxBinIdxC tx** | **ctxidxTable** | **ctxidxOffset** |
| sao_eo_class | 0 | FL, cMax = 2 | - na - | - na- | -na-* |
| | 1 | | - na - | - na - | - na -* |
| | 2 | | - na - | - na- | -na-* |
| *-- uses Decode Bypass | | | | | |

**Claims**

1. An image processing apparatus comprising at least one processor configured to:

   receive an encoded bitstream including Sample Adaptive Offset (SAO) parameters as:

   a) SAO type, comprising one of a Not Applied, Band Offset (BO) and Edge Offset (EO);
   b) offset absolute values for BO, when BO is set as the SAO type, or offset absolute values for EO, when EO is set as the SAO type;
   c) offset sign and BO band position, indicating a displacement of the band offset, in the event BO is set as the SAO type; and
   d) EO class which represents one of four classes indicating direction when EO is set as the SAO type;

   wherein the encoded bitstream comprises a sequence of bins representing SAO parameters which is ordered as: (i) a first bin of the SAO type which is coded using context mode, before (ii) the remaining bins of the SAO parameters, including a second bin of the SAO type, which remaining bins are coded using by-pass mode;
   wherein the at least one processor is configured to decode the SAO type which is binarized using truncated unary binarization; and
   wherein the at least one processor is configured to decode the EO class which is binarized using a fixed length code, when EO is set as the SAO type.

2. An image processing method comprising:

   receiving an encoded bitstream including Sample Adaptive Offset (SAO) parameters as:

   a) SAO type, comprising one of a Not Applied, Band Offset (BO) and Edge Offset (EO);
   b) offset absolute values for BO, when BO is set as the SAO type, or offset absolute values for EO, when EO is set as the SAO type;
   c) offset sign and BO band position, indicating a displacement of the band offset, in the event BO is set as the SAO type; and
   d) EO class which represents one of four classes indicating direction when EO is set as the SAO type;

   wherein the encoded bitstream comprises a sequence of bins representing SAO parameters which is ordered as: (i) a first bin representing the SAO type which is coded using context mode, before (ii) the remaining bins of the SAO parameters, including a second bin of the SAO type, which remaining bins are coded using by-pass mode;
   decoding the SAO type which is binarized using truncated unary binarization; and
   decoding the EO class which is binarized using a fixed length code, when EO is set as the SAO type.

3. Computer software comprising programming instructions which, when executed by one or more processors, cause the one or more processors to implement the method of claim 2

**Patentansprüche**

1. Bildverarbeitungseinrichtung, die mindestens einen Prozessor umfasst, ausgelegt zum:

   Empfangen eines codierten Bitstroms, einschließlich Abtastadaptiver-Offset- bzw. SAO(Sample-Adaptive-Offset)-Parameter als:

   a) SAO-Typ, umfassend Nicht-Angewandt oder Band-Offset (BO) oder Kanten-Offset (EO - Edge Offset);
   b) Offset-Absolutwerte für BO, wenn BO als SAO-Typ eingestellt ist, oder Offset-Absolutwerte für EO, wenn EO als SAO-Typ eingestellt ist;
   c) Offset-Vorzeichen und BO-Bandposition, eine Verschiebung des Band-Offsets angebend, falls BO als SAO-Typ eingestellt ist; und
   d) EO-Klasse, die eine von vier Klassen repräsentiert, die eine Richtung angeben, wenn EO als SAO-Typ eingestellt ist;

   wobei der codierte Bitstrom eine Folge SAO-Parameter repräsentierender Bins umfasst, die die folgende Reihenfolge aufweist: (i) ein erstes Bin des SAO-Typs, das unter Verwendung eines Kontextmodus codiert ist, vor (ii) den restlichen Bins der SAO-Parameter, einschließlich eines zweiten Bins des SAO-Typs, wobei die restlichen Bins unter Verwendung eines Bypass-Modus codiert sind;
   wobei der mindestens eine Prozessor ausgelegt ist zum Decodieren des SAO-Typs, der unter Verwendung abgeschnittener unärer Binärisierung binärisiert ist; und
   wobei der mindestens eine Prozessor ausgelegt ist zum Decodieren der EO-Klasse, die unter Verwendung eines Codes mit fester Länge binärisiert ist, wenn EO als SAO-Typ eingestellt ist.

2. Bildverarbeitungsverfahren, das Folgendes umfasst:

   Empfangen eines codierten Bitstroms, einschließlich Abtastadaptiver-Offset- bzw. SAO(Sample-Adaptive-Offset)-Parameter als:

   a) SAO-Typ, umfassend Nicht-Angewandt oder Band-Offset (BO) oder Kanten-Offset (EO - Edge Offset);
   b) Offset-Absolutwerte für BO, wenn BO als SAO-Typ eingestellt ist, oder Offset-Absolutwerte für EO, wenn EO als SAO-Typ eingestellt ist;
   c) Offset-Vorzeichen und BO-Bandposition, eine Verschiebung des Band-Offsets angebend, falls BO als SAO-Typ eingestellt ist; und
   d) EO-Klasse, die eine von vier Klassen repräsentiert, die eine Richtung angeben, wenn EO als SAO-Typ eingestellt ist;

   wobei der codierte Bitstrom eine Folge SAO-Parameter repräsentierender Bins umfasst, die die folgende Reihenfolge aufweist: (i) ein erstes den SAO-Typ repräsentierendes Bin, das unter Verwendung eines Kontextmodus codiert ist, vor (ii) den restlichen Bins der SAO-Parameter, einschließlich eines zweiten Bins des SAO-Typs, wobei die restlichen Bins unter Verwendung eines Bypass-Modus codiert sind;
   Decodieren des SAO-Typs, der unter Verwendung abgeschnittener unärer Binärisierung binärisiert ist; und
   Decodieren der EO-Klasse, die unter Verwendung eines Codes mit fester Länge binärisiert ist, wenn EO als SAO-Typ eingestellt ist.

3. Computersoftware, umfassend Programmieranweisungen, die bei Ausführung durch einen oder mehrere Prozessoren bewirken, dass der eine oder die mehreren Prozessoren das Verfahren nach Anspruch 2 implementieren.

**Revendications**

1. Appareil de traitement d'image comprenant au moins un processeur configuré pour : recevoir un train de bits codé comprenant des paramètres de décalage adaptatif d'échantillon (SAO) comme :

   a) un type de SAO, comprenant l'un parmi Non Appliqué, Décalage de Bande (BO) et Décalage de Bord (EO) ;
   b) des valeurs absolues de décalage pour BO, lorsque BO est défini comme le type de SAO, ou des valeurs absolues de décalage pour EO, lorsque EO est défini comme le type de SAO;
   c) un signe de décalage et une position de bande BO, indiquant un déplacement du décalage de bande, dans le cas où BO est défini comme le type de SAO; et

d) une classe de EO qui représente l'une de quatre classes indiquant la direction lorsque EO est défini comme le type de SAO;

dans lequel le train de bits codé comprend une séquence de segments représentant des paramètres de SAO qui est ordonnée comme suit : (i) un premier segment du type de SAO qui est codé en mode contextuel, avant (ii) les segments restants des paramètres de SAO, comprenant un deuxième segment du type de SAO, lesquels segments restants sont codés en mode évitement;

dans lequel l'au moins un processeur est configuré pour décoder le type de SAO qui est binarisé en utilisant une binarisation unaire tronquée; et

dans lequel l'au moins un processeur est configuré pour décoder la classe de EO qui est binarisée en utilisant un code de longueur fixe, lorsque EO est défini comme le type de SAO.

2. Procédé de traitement d'image comprenant de :

recevoir un train de bits codé comprenant des paramètres de décalage adaptatif d'échantillon (SAO) comme :

a) un type de SAO, comprenant l'un parmi Non Appliqué, Décalage de Bande (BO) et Décalage de Bord (EO) ;

b) des valeurs absolues de décalage pour BO, lorsque BO est défini comme le type de SAO, ou des valeurs absolues de décalage pour EO, lorsque EO est défini comme le type de SAO;

c) un signe de décalage et une position de bande BO, indiquant un déplacement du décalage de bande, dans le cas où BO est défini comme le type de SAO; et

d) une classe de EO qui représente l'une de quatre classes indiquant la direction lorsque EO est défini comme le type de SAO;

dans lequel le train de bits codé comprend une séquence de segments représentant des paramètres de SAO qui est ordonnée comme suit : (i) un premier segment représentant le type de SAO qui est codé en mode contextuel, avant (ii) les segments restants des paramètres de SAO, comprenant un deuxième segment du type de SAO, lesquels segments restants sont codés en mode évitement;

décoder le type de SAO qui est binarisé en utilisant une binarisation unaire tronquée; et

décoder la classe de EO qui est binarisée en utilisant un code de longueur fixe, lorsque EO est défini comme le type de SAO.

3. Logiciel informatique comprenant des instructions de programmation qui, lorsqu'elles sont exécutées par un ou plusieurs processeurs, amènent le ou les processeurs à mettre en œuvre le procédé selon la revendication 2.

FIG. 1

**FIG. 2**

EP 3 591 976 B1

**FIG. 3**

EP 3 591 976 B1

**EP 3 591 976 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **MAANI et al.** *SAO Type Coding Simplification'', JCTVC-I0246,* April 2012